## Europäisches Patentamt
## European Patent Office
## Office européen des brevets

(11) Veröffentlichungsnummer: **0 038 520**
**B1**

(12) EUROPÄISCHE PATENTSCHRIFT

(45) Veröffentlichungstag der Patentschrift:
11.07.84

(51) Int. Cl.³: **H 03 C 3/09**, H 04 L 27/12

(21) Anmeldenummer: **81102865.3**

(22) Anmeldetag: **14.04.81**

(54) Verfahren zur Frequenzstabilisierung eines hochfrequenten freischwingenden Oszillators.

(30) Priorität: **22.04.80 DE 3015484**

(43) Veröffentlichungstag der Anmeldung:
**28.10.81 Patentblatt 81/43**

(45) Bekanntmachung des Hinweises auf die Patenterteilung:
**11.07.84 Patentblatt 84/28**

(84) Benannte Vertragsstaaten:
**AT BE CH FR GB IT LI LU NL SE**

(56) Entgegenhaltungen:
DE - A - 2 261 257
FR - A - 1 604 830
FR - A - 2 250 226
FR - A - 2 404 966
GB - A - 2 046 541
US - A - 4 068 198

SYSTEMS TECHNOLOGY, Nr. 19, September 1974,
Seiten 14-18 Liverpool, G.B. R. THOMPSON et al.:
"Digital angle modulation for data transmission"
MICROWAVE JOURNAL, Band 20, Nr. 4, April 1977,
Seiten 40-43, 46,47 Dedham, U.S.A. R.S. NAPIER et al.:
"18-40 GHz broadband frequency synthesizer
technique"

(73) Patentinhaber: SIEMENS AKTIENGESELLSCHAFT,
Berlin und München Wittelsbacherplatz 2,
D-8000 München 2 (DE)

(72) Erfinder: Kloeber, Peter, Dipl.-Ing., Uhdestrasse 20,
D-8000 München 71 (DE)
Erfinder: Müller, Friedrich, Dipl.-Ing., Maxhofstrasse 74,
D-8000 München 71 (DE)

ACTORUM AG

**Beschreibung**

Die Erfindung bezieht sich auf ein Verfahren zur Frequenzstabilisierung eines hochfrequenten freischwingenden Oszillators, insbesondere des Mikrowellenoszillators im Sendezweig einer Sende-Empfangseinrichtung für ein analog oder digital moduliertes Funksystem, bei dem in der Stabilisierungsschaltung zugleich eine digitale Frequenzmodulation erfolgt derart, dass ein Teil des Ausgangssignals des zu stabilisierenden freischwingenden Oszillators auf einen programmierbaren Frequenzteiler mit einem einstellbaren Teilungsfaktor gegeben wird, dessen dem digitalen Frequenzhub der Frequenzmodulation entsprechendes Ausgangssignal der geteilten Frequenz in einer Phasenvergleichsschaltung mit der stabilen Referenzfrequenz einer Referenzquelle verglichen wird und die entstehende Regelspannung die Frequenz des freischwingenden Oszillators auf einen dem Teilungsfaktor entsprechenden Wert mit der Frequenzstabilität der Referenzquelle einstellt.

Ein solches Verfahren, bei dem in einem Modulator neben der Frequenzstabilisierung eine Frequenzmodulation und eine Frequenzeinstellung des Oszillators erfolgen, ist durch die FR-A-1 604 830 bekannt.

Speziell bei höherfrequenten freischwingenden Oszillatoren genügt bei bestimmten Anwendungen die dem Oszillator eigene Frequenzstabilität nicht, so dass durch Stabilisierungsverfahren, z.B. Frequenz- oder Phasenvergleichs- und Nachregelschaltungen diese Oszillatoren auf die Frequenzstabilität einer hochstabilen Referenzquelle, z.B. eines Quarzoszillators gebracht werden müssen. Derartig hohe Anforderungen werden beispielsweise auch an die Frequenzstabilität eines Mikrowellenoszillators gestellt, der im Sendezweig einer Sende-Empfangseinrichtung für ein analog oder digital moduliertes Funksystem zur Nachrichtenübertragung zwischen sich längs vorgegebener Strecken bewegenden Sende-Empfangsstationen und längs dieser Strecken in vorgegebenen Abständen angeordneten, in beiden Streckenrichtungen wirksamen Sende-Empfangsstationen eingeschaltet ist. Ein Verfahren zur Stabilisierung eines solchen Mikrowellenoszillators ist durch die DE-C-2 744 110 bekannt.

Aus «Microwave Journal», Bd. 20, Nr. 4, April 1977, Seiten 40-43, 46, 47 ist ein 0,1 bis 18 GHz Frequenz-Synthesizer bekannt, der einen programmierbaren Frequenzteiler enthält.

Ferner ist durch die US-A-4 068 198 eine Modulationseinrichtung mit einer Phasenregelschleife bekannt, wobei die Regelschleife einen programmierbaren Frequenzteiler enthält, der die Ausgangsfrequenz eines spannungsgeregelten Oszillators teilt unter Berücksichtigung der Tatsache, ob als Information eine binäre 1 oder 0 zu übertragen ist.

Durch die DE-A1-2 261 257 ist eine Steuerschaltung insbesondere für Telegrafiesender zum Erzeugen von zwei Frequenzen eines variablen Oszillators als Funktion von zwei verschiedenen Regeln eines Steuersignals bekannt, wobei die Frequenz des Oszillators durch eine Phasenverriegelungsschleife bestimmt ist. Diese umfasst eine zählende Teilerschaltung, die mit einem Sollwert programmierbar ist, sowie einen Phasenkompensator, der von der Ausgangsfrequenz der Teilerschaltung und einem Frequenznormal gesteuert wird.

Ein weiterer Frequenzmodulator zum Erhalt logischer Signale, der einen geregelten Oszillator und einen Frequenzteiler im Schaltungskreis enthält, ist durch die FR-A-2 250 226 bekannt.

Der Erfindung liegt die Aufgabe zugrunde, ein Verfahren der eingangs beschriebenen Art dahingehend zu verbessern, dass zusätzlich zur Frequenzstabilisierung in einfacher Weise eine Frequenzmodulation und Frequenzeinstellung möglich ist.

Diese Aufgabe wird mit einem Verfahren der eingangs beschriebenen Art gemäss der Erfindung in der Weise gelöst, dass der ausgekoppelte Teil der Ausgangsleistung des zu stabilisierenden freischwingenden Oszillators in einem Mischer mit dem vervielfachten Signal eines mit Hilfe einer Referenzfrequenz einer weiteren Referenzquelle stabilisierten Grundwellenoszillators gemischt und das hochfrequente Ausgangssignal des Mischers dem programmierbaren Teiler zugeführt wird, dessen in seiner Frequenz geteiltes Signal in der Phasenvergleichsschaltung mit der Referenzfrequenzquelle verglichen wird, die einstellbar ausgeführt ist derart, dass die Signalfrequenz der Referenzquelle in einem programmierbaren Frequenzteiler um einen bestimmten Faktor geteilt und mit dem um einen festen Faktor frequenzgeteilten Referenzsignal der weiteren Referenzquelle der Nachregelschaltung des Grundwellenoszillators in einer zweiten Phasenvergleichsschaltung verglichen wird, und dass zur Einstellung der Frequenz des Grundwellenoszillators ein Teil seines Ausgangssignals über einen programmierbaren Frequenzteiler (Teilungsfaktor p) auf eine weitere Phasenvergleichsschaltung gegeben und mit dem in der Frequenz geteilten Referenzsignal der weiteren Referenzquelle verglichen wird.

Vorteilhafte Ausgestaltungen und Weiterbildungen des erfindungsgemässen Verfahrens sind in den Unteransprüchen angegeben.

Nachstehend wird die Erfindung anhand von in der Zeichnung dargestellten Ausführungsbeispielen näher erläutert.

Es zeigen:

Fig. 1 das Blockschaltbild einer Stabilisierungsschaltung mit digitaler Frequenzmodulation,

Fig. 2 das entsprechende Blockschaltbild mit einer Erweiterung des Modulationsprinzips zu quasianaloger Frequenzmodulation,

Fig. 3 das Blockschaltbild einer Stabilisierungsschaltung mit Frequenzmodulation mit mehreren Referenzquellen und

Fig. 4 ein weiteres Ausführungsbeispiel einer Stabilisierungsschaltung mit digitaler Frequenzmodulation.

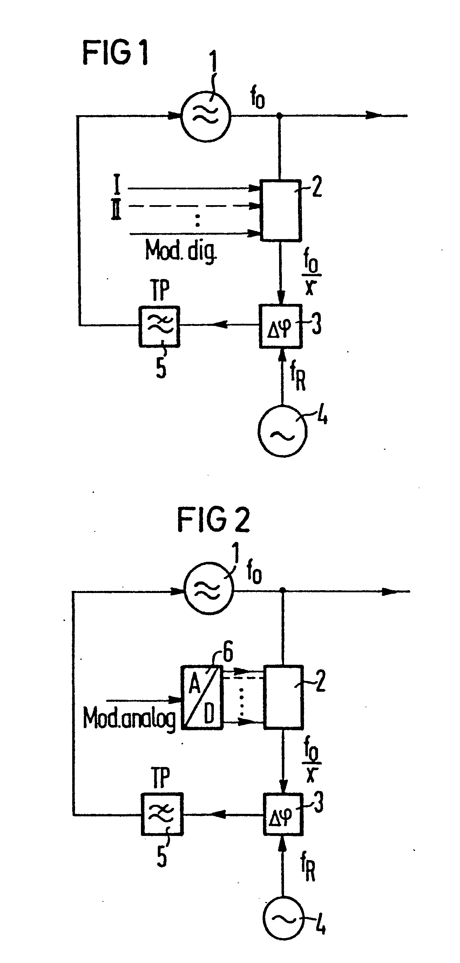

Bei der Stabilisierungsschaltung gemäss Fig. 1 ist der freischwingende hochfrequente Oszillator der Frequenz $f_o$ mit 1 bezeichnet. Er gibt einen Teil seines Ausgangssignals auf einen programmierbaren Teiler 2, der je nach Teilverhältnis aus einem oder mehreren integrierten Bausteinen besteht, so dass die Oszillatorfrequenz $f_o$ um einen Teilungsfaktor x geteilt wird. Die geteilte Frequenz $f_o/x$ entspricht dabei genau dem digitalen Frequenzhub der Frequenzmodulation. Der Teilungsfaktor x kann nun je nach Schaltzustand an den Programmiereingängen I, II ... des Teilers 2 den Wert x = n oder x = n + 1 haben bzw. im Falle einer mehrkanaligen FSK-Modulation x = n + m, wobei n = 0, 1, ... und m < n die Anzahl der einzelnen FSK-Frequenzen ist.

Die geteilte Frequenz $f_o/x$ wird nun in einer Phasenvergleichsschaltung 3 mit der stabilen Referenzfrequenz $f_R$ der Referenzquelle 4 verglichen. Die in der Phasenvergleichsschaltung 3 entstehende Regelspannung wird über einen Tiefpass 5 auf den frequenzsteuernden Eingang des Oszillators 1 geschaltet, so dass im eingeregelten Zustand die geteilte Frequenz $f_o/x = f_R$ wird, d.h. der Oszillator 1 die Frequenzstabilität der Referenzquelle 4 besitzt. Ändert sich nun im Sinne des digitalen Modulationssignals (Mod. digital) der Teilungsfaktor x z.B. von x = n auf x = n + 1, so wird der Oszillator 1 um den Betrag $f_R$ in der Frequenz angehoben, da über die Nachregelschaltung auch $f_o/n + 1 = f_R$ werden muss. Das heisst, mit steigendem Teilungsfaktor x steigt auch die stabilisierte Frequenz $f_o$. Die maximale Modulationsfrequenz muss kleiner als die Referenzfrequenz $f_R$ sein.

Die Schaltung nach Fig. 2 enthält eine Erweiterung des Modulationsprinzips zu quasianaloger Frequenzmodulation. Dabei wird das analoge Modulationssignal (Mod. analog) über einen Analog-Digital-Wandler 6 in ein bitparalleles Datenmuster umgewandelt, das seinerseits über die Programmiereingänge I, II ... des Teilers 2 dessen Teilungsfaktor x bestimmt. Von der Anzahl der Quantisierungsstufen des Analog-Digital-Wandlers 6 wird die Anzahl der verschiedenen Teilungsfaktoren bestimmt und damit die Zahl der auftretenden Frequenzsprünge des Oszillators 1. Hat der Analog-Digital-Wandler z.B. vier digitale Ausgänge, so können damit maximal 16 verschiedene Teilungsfaktoren eingestellt werden. Der maximale Frequenzhub des Oszillators 1 beträgt also 15 $f_R$.

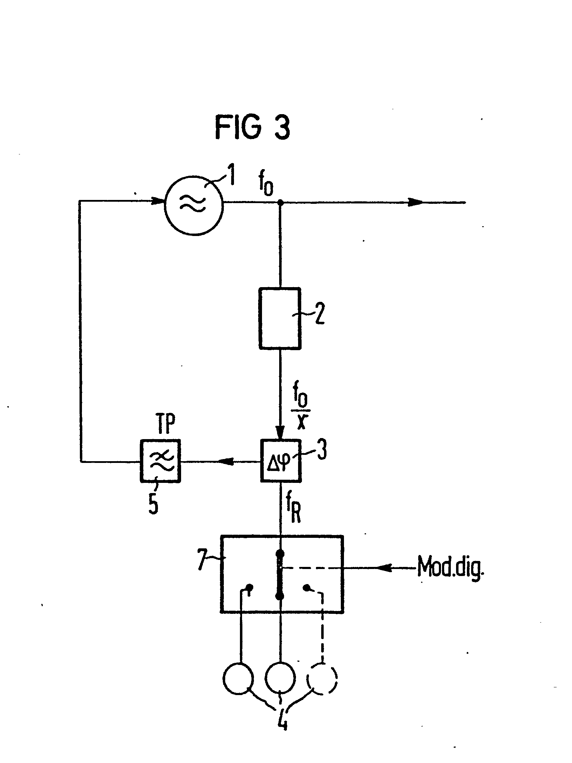

Die Schaltung nach Fig. 3 stellt eine Variante des Stabilisierungs- bzw. Modulationsprinzips dar. Hierbei bleibt das Teilungsverhältnis x des Teilers 2 fest, d.h. er muss nicht programmierbar sein. Die Referenzfrequenz $f_R$ ändert sich um den Betrag $\triangle f_R$ im Sinne des digitalen Modulationssignals, so dass der Frequenzhub des Oszillators $\triangle f_R \cdot x$ beträgt. Die Variation der Referenzfrequenz $f_R$ wird durch Umschaltung zwischen mehreren Referenzquellen 4 bewirkt. Hierzu ist eine Schalteinrichtung 7 mit Umschaltern vorgesehen, die von digitalen Modulationssignalen (Mod. digital) gesteuert wird.

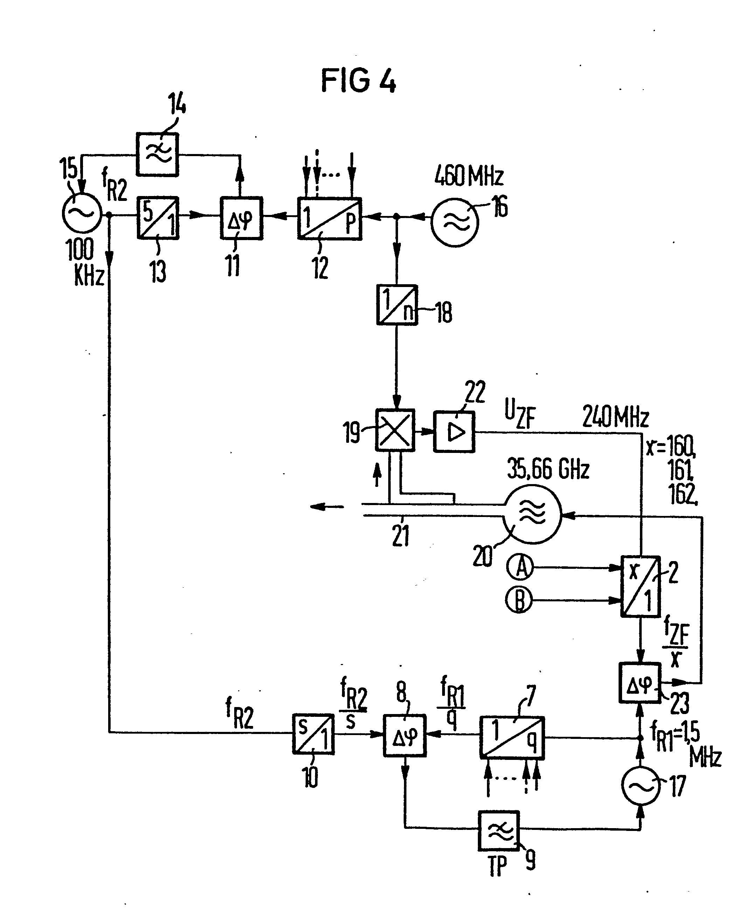

Fig. 4 zeigt ein Ausführungsbeispiel einer Stabilisierungsschaltung mit digitaler Frequenzmodulation und Frequenzeinstellung, wie sie beispielsweise für ein linienförmiges Zugbeeinflussungs-System anwendbar ist. Zur Veranschaulichung sind für die Frequenzen der Oszillatoren und die Frequenzteiler bzw. -vervielfacher Zahlenwerte eingetragen. Der in seiner Frequenz zu stabilisierende Mikrowellenoszillator ist mit 20 bezeichnet. Von seinem Signal wird in einem Richtkoppler 21 ein Teil ausgekoppelt und einem Mischer 19 zugeführt. In diesem wird es mit dem in einem Vervielfacher 18 um den Faktor n vervielfachten Signal eines Grundwellenoszillators 16 der Frequenz $f_o$ (z.B. $f_o$ = 460 MHz) gemischt. Das aus der Mischung entstandene hochfrequente Signal $U_{ZF}$ (z.B. $f_{ZF}$ = 240 MHz) wird über einen Verstärker 22 auf den programmierbaren Teiler 2 gegeben und in diesem in der Frequenz auf $\frac{f_{ZF}}{x} = \frac{f_{20} - n \cdot f_o}{x}$

geteilt und in der nachfolgenden Phasenvergleichsschaltung 23 mit der Referenzfrequenz $f_{R1}$ einer Referenzquelle 17 verglichen. Der programmierbare Teiler 2 weist einen Steuereingang A auf für die Modulationseinstellung und einen Eingang B zur Einstellung eines sogenannten Ruhezustandes. Im dargestellten Beispiel wird über den Steuereingang A der Teilungsfaktor des Teilers 2 modulationsbedingt zu x = 160 oder x = 162 eingestellt. Über den Eingang B wird der Teilungsfaktor x = 161 eingestellt. Dieser sogenannte Ruhezustand dient als dritter Frequenzzustand zusätzlich zu den beim FSK-Prinzip vorhandenen zwei diskreten Frequenzzuständen und gewährleistet, dass bei der Nachrichtenübertragungsrichtung von den beweglichen Sende-Empfangsstationen auf die ortsfesten alle beweglichen Sende-Empfangsstationen bis auf eine gerade sendende einen sogenannten Ruhezustand einnehmen, indem sie zwar Nachricht von den ortsfesten Sende-Empfangsstationen aufnehmen, nicht aber die Sender der einen aufgerufenen beweglichen Sende-Empfangsstation stören können.

Bei modulationsgesteuertem ansteigendem Teilungsfaktor x, beispielsweise von x = n (z.B. n = 160) auf x = n + 2, wird die Frequenz des Mikrowellenoszillators $f_{20}$ ebenfalls um den Betrag 2 · $f_{R1}$ angehoben.

Der Grundwellenoszillator 16 wird hierbei durch eine Nachregelschaltung nach dem Synthesizerprinzip mit Hilfe einer Referenzfrequenz $f_{R2}$ einer Referenzquelle 15 stabilisiert und kann über einen programmierbar einstellbaren Teiler 12 (Teilungsfaktor p) in der Frequenz in festen Frequenzstufen eingestellt werden. Hierfür wird ein Teil des Ausgangssignals des Grundwellenoszillators 16 über den programmierbaren Teiler 12 auf eine Phasenvergleichsschaltung 11 gegeben und mit dem in der Frequenz im Teiler 13 geteilten Referenzsignal $f_{R2}$ der Referenzquelle 15 verglichen. Der Grundwellenoszillator 16 wird durch eine Regelspannung, die in der Phasenvergleichsschaltung 11 entsteht, über einen Tiefpass 14 in der Frequenz so nachgeregelt, dass

seine Frequenz $f_o$ immer gleich $\frac{p \cdot f_{R2}}{5}$ ist.

Diese einstellbare Frequenzstabilisierung ermöglicht es, in mehreren einstellbaren Frequenzbereichen mit Hilfe einer Referenzfrequenz $f_{R2}$ eine Anzahl von Funkgeräten in ihrem frequenzmässigen Verhalten zu synchronisieren.

Im hier beschriebenen Ausführungsbeispiel ist auch die Referenzfrequenz $f_{R1}$ einstellbar ausgeführt, wodurch vermieden wird, dass man Interferenzen bedingende Frequenzen der Funkgeräte eines Funkbereichs erhält. Die Referenzfrequenz $f_{R1}$ ist um den Betrag q · $\triangle f_{R1}$ einstellbar, wobei q z.B. zwischen $q_o$ + 1 und $q_o$ + 20 liegen kann. Dazu wird das Signal eines zunächst als freischwingend gedachten Oszillators 17 der Frequenz $f_{R1}$ in einem programmierbaren Frequenzteiler 7 um den Faktor q geteilt und mit dem um den Faktor s in einem Teiler 10 frequenzgeteilten Referenzsignal der Frequenz $f_{R2}$ verglichen, so dass $f_{R2}/s = f_{R1}/q$ wird. Steigt z.B. der Faktor q um 1 an, so erhöht sich auch die Referenzfrequenz $f_{R1}$ um den Betrag $\triangle f_{R1} = f_{R2}/s$ und damit auch die Frequenz des Mikrowellenoszillators 20 um $\triangle f_{R1} \cdot x$.

## Patentansprüche

1. Verfahren zur Frequenzstabilisierung eines hochfrequenten freischwingenden Oszillators, insbesondere des Mikrowellenoszillators im Sendezweig einer Sende-Empfangseinrichtung für ein analog oder digital moduliertes Funksystem, bei dem in der Stabilisierungsschaltung zugleich eine digitale Frequenzmodulation erfolgt derart, dass ein Teil des Ausgangssignals des zu stabilisierenden freischwingenden Oszillators (20) auf einen programmierbaren Frequenzteiler (2) mit einem einstellbaren Teilungsfaktor (x) gegeben wird, dessen dem digitalen Frequenzhub der Frequenzmodulation entsprechendes Ausgangssignal der geteilten Frequenz $(f_o/x, f_{ZF}/x)$ in einer Phasenvergleichsschaltung (23) mit der stabilen Referenzfrequenz $(f_{R1})$ einer Referenzquelle (17) verglichen wird und die entstehende Regelspannung die Frequenz des freischwingenden Oszillators (20) auf einen dem Teilungsfaktor entsprechenden Wert mit der Frequenzstabilität der Referenzquelle (17) einstellt, dadurch gekennzeichnet, dass der ausgekoppelte Teil der Ausgangsleistung des zu stabilisierenden freischwingenden Oszillators (20) in einem Mischer (19) mit dem vervielfachten Signal eines mit Hilfe einer Referenzfrequenz $(f_{R2})$ einer weiteren Referenzquelle (15) stabilisierten Grundwellenoszillators (16) gemischt und das hochfrequente Ausgangssignal des Mischers (19) dem programmierbaren Teiler (2) zugeführt wird, dessen in seiner Frequenz geteiltes Signal in der Phasenvergleichsschaltung (23) mit der Referenzfrequenzquelle (17) verglichen wird, die einstellbar ausgeführt ist derart, dass die Signalfrequenz der Referenzquelle (17) in einem programmierbaren Frequenzteiler (7) um einen bestimmten Faktor (q) geteilt und mit dem um einen festen Faktor (s) frequenzgeteilten Referenzsignal $(f_{R2})$ der weiteren Referenzqulle (15) der Nachregelschaltung des Grundwellenoszillators (16) in einer zweiten Phasenvergleichsschaltung (8) verglichen wird, und dass zur Einstellung der Frequenz des Grundwellenoszillators (16) ein Teil seines Ausgangssignals über einen programmierbaren Frequenzteiler (12) (Teilungsfaktor p) auf eine weitere Phasenvergleichsschaltung (11) gegeben und mit dem in der Frequenz geteilten Referenzsignal $(f_{R2})$ der weiteren Referenzquelle (15) verglichen wird.

2. Verfahren nach Anspruch 1, dadurch gekennzeichnet, dass die Variation der Referenzquelle $(f_R)$ durch Umschaltung zwischen zwei oder mehreren Referenzquellen (4) erfolgt.

3. Verfahren nach Anspruch 1 oder 2, dadurch gekennzeichnet, dass der programmierbare Teiler (2) einen Steuereingang (A) für die Modulationseinstellung und einen Eingang (B) zur Einstellung eines Ruhezustandes als dritter Frequenzzustand aufweist.

## Claims

1. A process for the frequency stabilisation of a high-frequency free-swinging oscillator, in particular of the micro-wave oscillator in the transmitting branch of a transmitting-receiving device for a radio system modulated in analogue or digital fashion, wherein in the stabilisation circuit a digital frequency modulation is simultaneously effected in such a manner that part of the output signal of the free-swinging oscillator (20) to be stabilised is transmitted onto a programmable frequency divider (2) which has an adjustable dividing factor (x) and whose output signal of the divided frequency $(f_o/x, f_{ZF}/x)$, which corresponds to the digital frequency fluctuation of the frequency modulation, is compared with the stable referency $(f_{R1})$ of a reference source (17) in a phase comparison circuit (23) and the resultant regulating voltage adjusts the frequency of the free-swinging oscillator (20) to a value which corresponds to the dividing factor and has the frequency stability of the reference source (17), characterised in that the output-coupled portion of the output power of the free-swinging oscillator (20) to be stabilised is mixed in a mixer (19) with the multiplied signal of a fundamental wave oscillator (16) which is stabilised with the aid of a reference frequency $(f_{R2})$ of a further reference source (15) and the high-frequency output signal of the mixer (19) is fed to the programmable divider (2), whose frequency divided signal is compared with the reference frequency source (17) in the phase comparison circuit (23), which reference frequency source is designed so as to be adjustable in such a manner that the signal frequency of the reference source (17) is divided by a specific factor (q) in a programmable frequency divider (7) and compared with the reference signal $(f_{R2})$ of the further reference source (15) of the readjusting circuit of the fundamental wave oscillator (16), which reference signal is frequency-divided by a fixed factor (s) in a second phase comparison circuit (8), and that in order to adjust the frequency of the fundamental wave oscillator (16) a portion of its output signal is fed to a further phase comparison circuit (11) by means of a programmable frequency divider (12) (dividing factor p) and compared with the divided frequency of the reference signal $(f_{R2})$ of the further reference source (15).

2. A process as claimed in claim 1, characterised in that the variation of the reference source $(f_R)$ is effected by a change-over between two or more reference sources (4).

3. A process as claimed in claim 1 or 2, characterised in that the programmable divider (2) has a control input (A) for the modulation adjustment and an input (B) for adjusting a rest position as a third frequency state.

## Revendications

1. Procédé pour la stabilisation en fréquence d'un oscillateur libre à haute fréquence, notamment l'oscillateur micro-ondes dans la branche d'émission d'un dispositif émetteur-récepteur pour un système de radiocommunication modulé analogiquement ou numériquement, dans lequel dans le circuit de stabilisation une modulation de fréquence numérique a lieu simultanément de manière qu'une partie du signal de sortie de l'oscillateur libre (20) devant être stabilisé est appliquée à un diviseur de fréquence programmable (2), possédant un facteur de division (x) réglable, dont le signal de sortie, qui présente la fréquence divisée ($f_o/x$, $f_{ZF}/x$) et correspond à l'excursion en fréquence numérique de la modulation de fréquence, est comparé à la fréquence de référence stable ($f_{R1}$) d'une source de référence (17), dans un circuit de comparaison de phase (23), et la tension de réglage qui apparaît règle la fréquence de l'oscillateur libre (20) sur une valeur qui correspond au facteur de division, avec la stabilité en fréquence de la source de référence (17), caractérisé par le fait que la partie prélevée de la puissance de sortie de l'oscillateur libre (20) devant être stabilisé est mélangée, dans un mélangeur (19), avec le signal multiplié d'un oscillateur pour onde fondamentale (16) stabilisé à l'aide d'une fréquence de référence ($f_{R2}$) d'une autre source de référence (15), et le signal de sortie à haute fréquence du mélangeur (19) est appliqué au diviseur programmable (2) dont le signal, divisé en fréquence est comparé, dans le circuit de comparaison de phase (23), à la source de fréquence de référence (17) qui est conçue de façon réglable de manière que la fréquence de signal de la source de référence (17) soit divisée, dans un diviseur de fréquence programmable (7), par un facteur déterminé (q) et soit comparée au signal de référence ($f_{R2}$), divisé en fréquence par un facteur fixe (s), de l'autre source de référence (15) du circuit de réajustage de l'oscillateur pour onde fondamentale (16), dans un second circuit de comparaison de phase (8), et que pour régler la fréquence de l'oscillateur pour onde fondamentale (16) une partie de son signal de sortie est appliquée à un autre circuit de comparaison de phase (11), par l'intermédiaire d'un diviseur de fréquence programmable (12) (facteur de division p), et est comparée au signal de référence ($f_{R2}$), divisé en fréquence, de l'autre source de référence (15).

2. Procédé suivant la revendication 1, caractérisé par le fait que la variation de la source de référence ($f_R$) a lieu par commutation entre deux sources de référence ou plus (4).

3. Procédé suivant la revendication 1 ou 2, caractérisé par le fait que le diviseur programmable (2) comporte une entrée de commande (A) pour le réglage de la modulation, et une entrée (B) pour le réglage d'un état de repos en tant que troisième état de fréquence.

# FIG 1

# FIG 2

# FIG 3

## FIG 4